# EUROPEAN PATENT SPECIFICATION

(11) **EP 0 855 399 B1**
(45) Date of publication and mention of the grant of the patent: **02.05.2003**
(21) Application number: 97309120.0
(22) Date of filing: 13.11.1997
(51) Int. Cl.: C07F 7/18, C23C 16/18

(54) **Precursor with alkylaminosilylolefin ligands to deposit copper and method for same**
Alkylaminosilylolefin-Ligand enthaltende Vorläuferverbindungen zur Abscheiden von Kupfer
Précurseur contenant un alkylaminosilylolefine ligand pour le dépôt de cuivre

(30) Priority: 23.01.1997 US 786698
(43) Date of publication of application: 29.07.1998
(73) Proprietor: SHARP KABUSHIKI KAISHA, Osaka-shi, Osaka-fu 545-0013 (JP); SHARP MICROELECTRONICS TECHNOLOGY, INC., Camas, WA 98607 (US)
(72) Inventor: Senzaki, Yoshihide, No. N133 Vancouver, WA98683 (US)
(74) Representative: West, Alan Harry

(56) References cited:
- US-A- 5 273 775
- CHOI E S ET AL: "CHEMICAL VAPOR DEPOSITION OF COPPER WITH A NEW METALORGANIC SOURCE" APPLIED PHYSICS LETTERS, vol. 68, no. 7, 12 February 1996, pages 1017-1019, XP000559982

## Description

This invention relates generally to integrated circuit processes and fabrication, and more particularly, to a precursor and method, having enhanced temperature stability, used to deposited copper on selected integrated circuit surfaces.

The demand for progressively smaller, less expensive, and more powerful electronic products, in turn, fuels the need for smaller geometry integrated circuits (ICs) on larger substrates. It also creates a demand for a denser packaging of circuits onto IC substrates. The desire for smaller geometry IC circuits requires that the interconnections between components and dielectric layers be as small as possible. Therefore, research continues into reducing the width of via interconnects and connecting lines. The conductivity of the interconnects is reduced as the area of the interconnecting surfaces is reduced, and the resulting increase in interconnect resistivity has become an obstacle in IC design. Conductors having high resistivity create conduction paths with high impedance and large propagation delays. These problems result in unreliable signal timing, unreliable voltage levels, and lengthy signal delays between components in the IC. Propagation discontinuities also result from intersecting conduction surfaces that are poorly connected, or from the joining of conductors having highly different impedance characteristics.

There is a need for interconnects and vias to have both low resistivity, and the ability to withstand process environments of volatile ingredients. Aluminum and tungsten metals are often used in the production of integrated circuits for making interconnections or vias between electrically active areas. These metals are popular because they are easy to use in a production environment, unlike copper which requires special handling.

Copper (Cu) would appear to be a natural choice to replace aluminum in the effort to reduce the size of lines and vias in an electrical circuit. The conductivity of copper is approximately twice that of aluminum and over three times that of tungsten. As a result, the same current can be carried through a copper line having nearly half the width of an aluminum line.

The electromigration characteristics of copper are also much superior to those of aluminum. Aluminum is approximately ten times more susceptible than copper to degradation and breakage due to electromigration. As a result, a copper line, even one having a much smaller cross-section than an aluminum line, is better able to maintain electrical integrity.

There have been problems associated with the use of copper, however, in IC processing. Copper pollutes many of the materials used in IC processes and, therefore barriers are typically erected to prevent copper from migrating. Elements of copper migrating into these semiconductor regions can dramatically alter the conduction characteristics of associated transistors. Another problem with the use of copper is the relatively high temperature needed to deposit it on, or removing it from, an IC surface. These high temperatures can damage associated IC structures and photoresist masks.

It is also a problem to deposit copper onto a substrate, or in a via hole, using the conventional processes for the deposition of aluminum when the geometries of the selected IC features are small. That is, new deposition processes have been developed for use with copper, instead of aluminum, in the lines and interconnects of an IC interlevel dielectric. It is impractical to sputter metal, either aluminum or copper, to fill small diameter vias, since the gap filling capability is poor. To deposit copper, first, a physical vapor deposition (PVD), and then, a chemical vapor deposition (CVD) technique, have been developed by the industry.

With the PVD technique, an IC surface is exposed to a copper vapor, and copper is caused to condense on the surfaces. The technique is not selective with regard to surfaces. When copper is to be deposited on a metallic surface, adjoining non-conductive surfaces must either be masked or etched clean in a subsequent process step. As mentioned earlier, photoresist masks and some other adjoining IC structures are potentially damaged at the high temperatures at which copper is processed. The CVD technique is an improvement over PVD because it is more selective as to which surfaces copper is deposited on. The CVD technique is selective because it is designed to rely on a chemical reaction between the metallic surface and the copper vapor to cause the deposition of copper on the metallic surface.

In a typical CVD process, copper is combined with a ligand, or organic compound, to help insure that the copper compound becomes volatile, and eventually decomposes, at consistent temperatures. That is, copper becomes an element in a compound that is vaporized into a gas, and later deposited as a solid when the gas decomposes. Selected surfaces of an integrated circuit, such as diffusion barrier material, are exposed to the copper gas, or precursor, in an elevated temperature environment. When the copper gas compound decomposes, copper is left behind on the selected surface. Several copper gas compounds are available for use with the CVD process. It is generally accepted that the configuration of the copper gas compound, at least partially, affects the ability of the copper to be deposited on to the selected surface.

Cu⁺²(hfac)₂, or copper (II) hexafluoroacetylacetonate, precursors have previously been used to apply CVD copper to IC substrates and surfaces. However, these Cu⁺² precursors are notable for leaving contaminates in the deposited copper, and for the relatively high temperatures that must be used to decompose the precursor into copper. Currently, more success has been found with the use of Cu⁺¹(hfac) compounds to apply copper. Norman, et al., U.S. Patent No. 5,322,712, discloses a (hfac)Cu(tmvs), or copper hexafluoroacetylacetonate trimethylvinylsilane, precursor that is the industry standard at the time of this writing. Alternately, tmvs is known as vtms, or vinyltrimethylsilane. This precursor is useful because it can be used at relatively low temperatures, approximately 200°C. In addition, the film resisitivity of copper applied with this method is very good, approaching the physical limit of 1.7µΩ-cm. However, the adhesiveness between copper deposited with this precursor and the surface to which it is deposited is not always good. Also, the precursor is not especially stable, and can have a relatively short shelf life if not refrigerated. Various ingredients have been added to (hfac)Cu(tmvs) to improve its adhesiveness, temperature stability, and the rate at which it can be deposited on an IC surface.

It is generally acknowledged in the industry that (hfac)Cu(tmvs) becomes unstable, arid begins to decompose, above 35° C. Use of a (hfac)Cu(tmvs) precursor stored at this temperature leads to undesirable process results. Typically, the precursor is a liquid at room temperature, and must be converted to a vapor form. In interacting with a heated target surface, the vaporized precursor first cleaves the tmvs ligand, and then the hfac, leaving Cu on the target surface. During this process a disproportionation reaction occurs in which uncharged atoms of Cu are left on the surface, while volatile forms of Cu⁺²(hfac)₂ and the tmvs ligand are exhausted through the system.

As an unstable precursor is heated to a vapor, the tmvs ligand cleaves unevenly from the precursor; some cleavage, or decomposition, occurs at low temperature, and some at higher temperatures. Because the precursor decomposes at low temperatures, the precursor vacuum pressure, or partial pressure, remains undesirably low, resulting in low Cu deposition rates, uneven surfaces, and variances in surface conductances. The effectivity of (hfac)Cu(tmvs) stored at temperatures lower than 35° C is also unpredictable. A "fresh" batch of precursor, or precursor stored at temperatures well below room temperature, is used to guarantee predictable processes.

Various additives have been mixed with the (hfac)Cu(tmvs) precursor to improve its temperature stability. It is well known to blend hexafluoroacetylacetone (H-hfac), tmvs, and other chemical agents to improve temperature stability. Baum et al., in "Ligand-stabilized copper(I) hexafluoroacetylacetonate complexes: NMR spectroscope and the nature of the copper-alkene bond", J. Organomet. Chem., 425, 1992, pp. 189-200, disclose alkene groups affecting improvement in the stability of Cu precursors. They also qualitatively analyze the nature of sigma and pi bonds in the Cu-alkene bond of a (hfac)Cu(alkene) complex.

Choi et al., in "Chemical vapor deposition of copper with a new metalorganic source", Appl. Phys. Lett. 68 (7), 12 Feb. 1996, pp. 1017-1019, disclose trimethoxyvinylsilane (tmovs) as a ligand to improve the temperature stability of Cu(hfac) complexes. Using the tmovs ligand, precursor stability up to the temperature of 70° C is reported. However, the addition of oxygen atoms between the methyl groups and the silicon atom of the ligand is still experimental. That is, the method has not been refined for production environments. There is concern that a precursor having a heavier molecular weight due to the addition of oxygen atoms to the ligand may require high bubbler temperatures to vaporize the precursor. Unexpected premature decomposition problems may result as higher vaporization temperatures and lower system pressures are required. It is also possible that the symmetry of the ligand molecules may tend to cause the precursor to solidify at room temperature. Further enhancement in the temperature stability of Cu(hfac) based precursors is desirable, and the use of other ligands to improve stability remains an area of ongoing research.

It would be advantageous if a method were found of making a Cu(hfac) based precursor stable over a wider range of temperatures, and to provide the precursor with a longer shelf life.

It would be advantageous if the ligand attached to the Cu(hfac) based precursor would cleave at a consistent temperature. Additionally, it would be advantageous if the ligand and the hfac would cleave at approximately the same temperature to yield consistent precursor decomposition.

It would be advantageous if the deposition temperature, or the temperature at which the (hfac)Cu(ligand) compound decomposes could be decreased, to simplify commercial processes. At the same time, it would be relatively low decomposition temperatures to deposit a thick layer of copper on selected IC surfaces. Further, it would be advantageous if the vapor pressure of the precursor in the gas phase could be modified with different molecule complexes bonded to the silicon atom of the ligand to change electron donation capacity, molecular weight, and molecular symmetry.

It would also be advantageous if water, H-hfac, H-hfac dihydrate (H-hfac·2H₂O), and silylolefin ligands were no longer necessary to blend with a Cu precursor to improve the thermal stability of the Cu precursor, and to improve the conductivity and deposition rate of deposited Cu.

It would be advantageous if a (hfac)Cu(ligand) could be designed to more readily retain a liquid form at room temperature so as to simplify precursor delivery in IC processes. Further, it would be advantageous if the viscosity of the liquid phase precursor could be modified with different molecule complexes bonded to the silicon atom of the ligand to change electron donation capacity, molecular weight, and molecular symmetry.

It would be advantageous if a method were found for including a wide variety of molecule groups bonded to the ligand silicon atom, forming a family of precursors to emphasize precursor characteristics suitable to specific production process requirements. It would also be advantageous if other atoms besides oxygen could be added to a silylolefin ligand to donate electrons to the Cu atom.

Accordingly, a volatile Cu precursor compound for the chemical vapor deposition (CVD) of Cu to selected surfaces is provided. The precursor compound comprises Cu⁺¹(hexafluoroacetylacetonate), or Cu⁺¹(hfac), and a silylolefin ligand including at least one alkylamino group having its nitrogen atom bonded to the silicon atom. That is, the ligand has a silicon atom to which three bonds are made; at least one of these bonds is made to the nitrogen atom of an alkylamino. The electron donation capability of the nitrogen in the alkylaminosilylolefin ligand provides a secure bond between the Cu and the ligand as the compound is heated to vaporization temperature.

In a preferred embodiment, the silylolefin ligand further includes alkyloxy groups bonded to the silicon atom when at least one alkylamino group is included. That is, the ligand comprises alkyl groups with oxygen, in addition to alkylamino groups. The electron donation capability of the oxygen in the (alkylamino)(alkyloxy)silylolefin ligand provides a secure bond between the Cu and the ligand as the compound is heated.

In another preferred embodiment, the silylolefin ligand further includes alkyl groups bonded to the silicon atom when at least one alkylamino group is included. The molecular weight of the (alkylamino)(alkyl)silylolefin ligand minimally suppresses the precursor volatility, since alkyl groups, not having either N or O atoms, have a smaller molecular weight than corresponding alkyloxy groups.

The preferred embodiment further includes an additive to the compound to create a precursor blend. The precursor blend further comprises a water vapor having a vacuum partial pressure. The water vapor is blended with the precursor so that the partial pressure of the water vapor is generally in the range of 0.5 to 5% of the precursor partial pressure, whereby the addition of water vapor to the precursor increases the rate of Cu deposition and the electrical conductivity of the deposited Cu.

A method for applying CVD Cu on a selected surface is also provided. The method comprising the steps of: a) establishing a predetermined vacuum partial pressure for a volatile Cu precursor compound including Cu⁺¹(hexafluoroacetylacetonate) and a silylolefin ligand including at least one alkylamino group bonded to the silicon atom; b) exposing each selected Cu-receiving surface to the precursor of step a); and, c) while continuing to carry out steps a) and b), depositing Cu on each Cu-receiving surface. The bond between the ligand and Cu prevents the decomposition of the precursor at low temperatures.

Fig. 1 is a schematic representation of the tmvs ligand (prior art).

Fig. 2 is a schematic representation of the tmovs ligand (prior art).

Fig. 3a is a schematic representation of the volatile Cu precursor compound of the present invention, using an alkylaminosilylolefin ligand, for the chemical vapor deposition (CVD) of Cu to selected surfaces.

Fig. 3b is a schematic representation of a preferred embodiment of the alkylaminosilylolefin ligand of Fig. 3a, in which a ligand includes three alkylamino groups.

Fig. 4a is a schematic representation of the ligand of Fig. 3a, further including alkyloxy groups bonded to the silicon atom.

Fig. 4b is a schematic representation of a preferred embodiment of the ligand of Fig. 4a, in which a ligand includes two amino groups and one alkyloxy group.

Fig. 5a is a schematic representation of the ligand of Fig. 3a, further including alkyl groups bonded to the silicon atom.

Fig. 5b is a schematic representation of a preferred embodiment of the ligand of Fig. 5a, in which a ligand includes two amino groups and one alkyl group.

Fig. 6a is a schematic representation of the ligand of Fig. 3a, further including alkyloxy and alkyl groups bonded to the silicon atom.

Fig. 6b is a schematic representation of a preferred embodiment of the ligand of Fig. 6a, in which a ligand includes an amino group, an alkyloxy group, and an alkyl group.

Fig. 7 is a block diagram of apparatus suitable to deposit Cu, with the precursor of the present invention, to selected surfaces (prior art).

Fig. 8 illustrates steps in the method of applying CVD Cu, using a precursor including a (alkylamino)silylolefin ligand, on a selected surface.

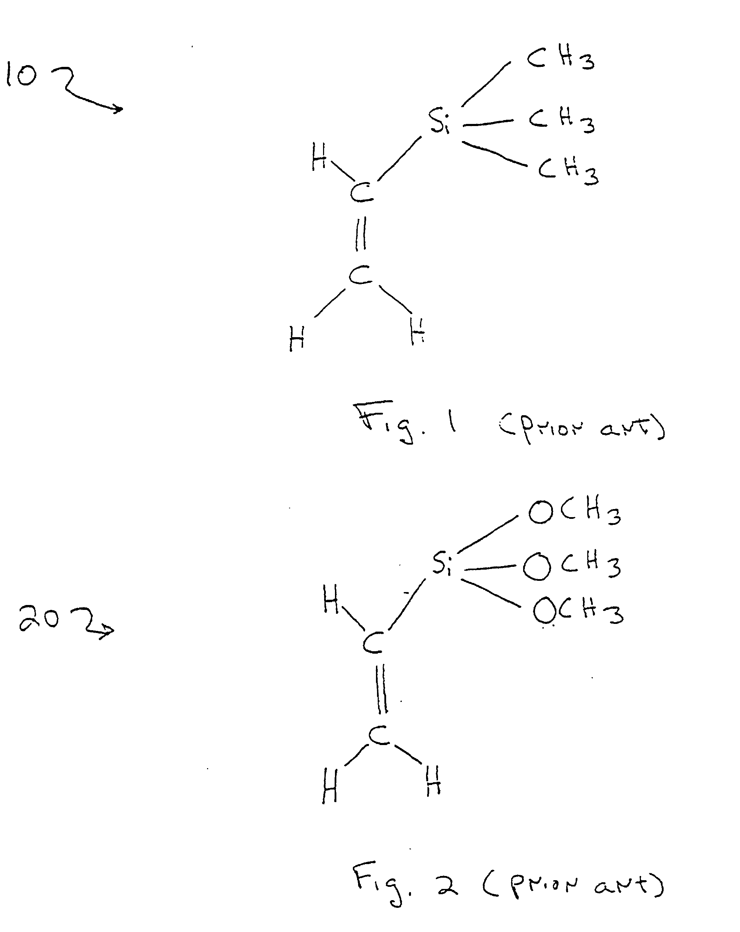

Fig. 1 is a schematic representation of the tmvs ligand 10 (prior art). The double lines between the two carbon atoms represent double bonds, while the single lines between the remaining atoms represent, weaker, single bonds. Cu becomes attached to tmvs ligand 10 through the carbon atoms. Cu and hfac form a relatively secure bond, and the resulting Cu⁺¹(hfac)⁻¹ complex has no net electrical charge. As is well known in the art, atoms or complexes having opposite charges combine to form very stable complexes. The bonding between the Cu⁺¹(hfac)⁻¹ complex, hereafter called Cu(hfac), and ligand 10 is relatively weak due to lack of opposing net charges. For this reason, tmvs ligand 10 is first to cleave from the Cu precursor as it is vaporized and applied to a target surface. While not intending to be bound by theory, it is believed that if the ligand were able to provide more electrons, the bond between the ligand and the Cu(hfac) could be improved, resulting in a Cu precursor with improved temperature stability.

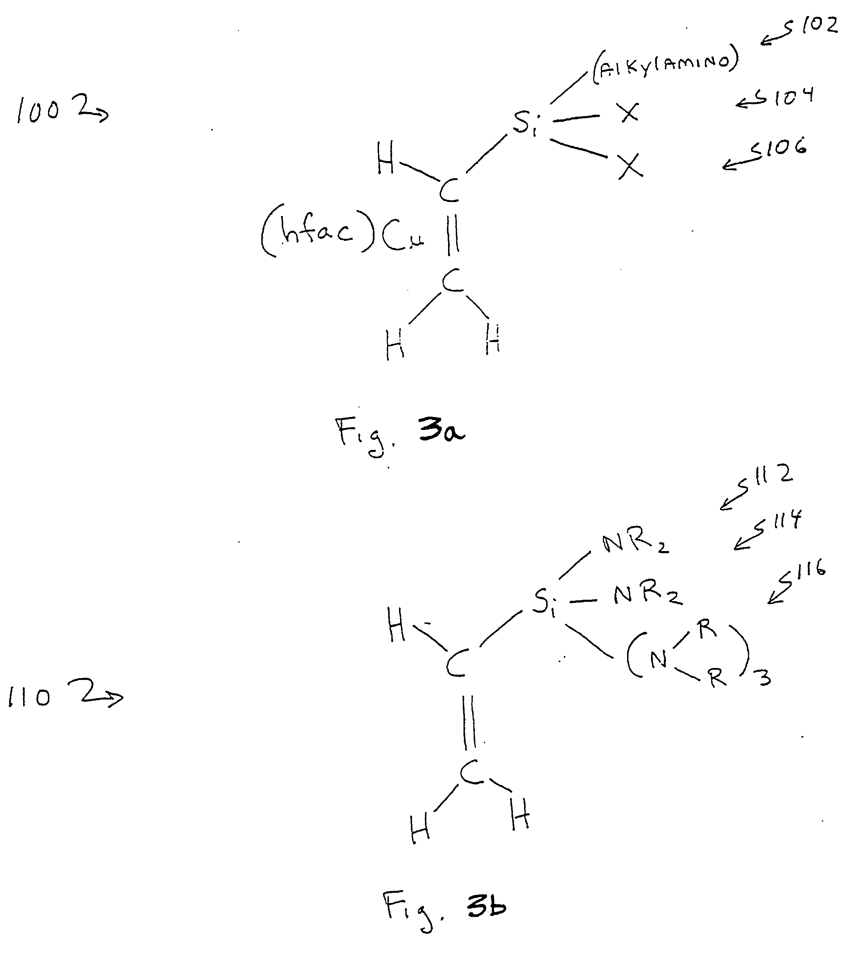

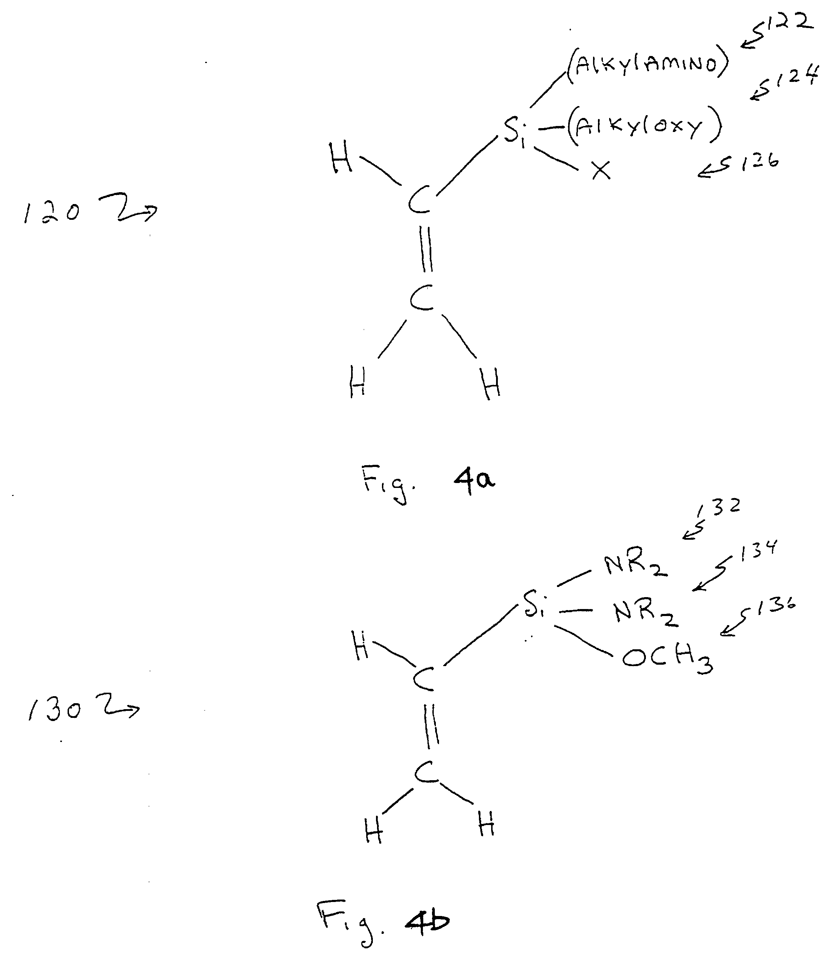

Fig. 2 is a schematic representation of the tmovs ligand 20 (prior art). The difference between tmovs ligand 20 and tmvs ligand 10 of Fig. 1 is in the addition of three oxygen atoms to the three methyl groups to form three methoxy groups bound to the silicon atom. It is believed that the oxygen atoms of tmovs ligand 20 readily donate electrons to the Cu(hfac) complex, and so, allow tmovs ligand 20 to more tightly bind itself to Cu(hfac). There exist a variety of models to explain the bonding between the double bond carbon atoms and the Cu atom; the quantitative bonding process is not entirely understood. The higher molecular weight of the three additional oxygen atoms will typically result in higher vaporization temperatures. An increase in the vaporization temperature of the precursor, without a corresponding increase in temperature stability, results in a precursor with inconsistent Cu decomposition characteristics that, in turn, cause Cu deposition problems. The present invention was invented in response to the need for a precursor that could be modified to adjust the number of electron donating atoms, and the type of molecule groups, comprising the ligand. ligand is a methoxydimethylvinylsilane (modmvs) ligand 50. Ligand 50 includes one methoxy group 52 and two methyl groups 54 and 56. The single oxygen atom of the methoxydimethyl group minimally suppresses the precursor volatility since ligand 50 has a relatively small molecular weight compared to the ligands 30 (Fig. 3a) and 40 (Fig. 3b).

Fig. 4a is a schematic representation of a Cu precursor 60 including an (alkyloxy)(alkyl) ligand of U.S. application Serial No.08/786,546, Attorney Docket No. SMT 256. Precursor compound 60 comprises Cu⁺¹(hfac), and a silylolefin ligand including at least one alkyloxy group, having at least two carbon atoms, bonded to the silicon atom. The remaining bonds to the silicon atom are made to alkyl groups. That is, three hydrocarbon groups are bonded to the silicon atom in one of the following three combinations: 3 alkyloxy groups, 2 alkyloxy groups and 1 alkyl group, or 1 alkyloxy group and 2 alkyl groups. The electron donation capability of the oxygen in the ethoxysilylolefin ligand provides a secure bond between the Cu and the alkylcxysilylolefin as compound 60 is heated to vaporization temperature.

Fig. 4b is a schematic representation of a preferred embodiment of precursor 60 of Fig. 4a, where the (alkyloxy)(alkyl)silylolefin ligand is a triethoxyvinylsilane (teovs) ligand 70. Three ethoxy groups (OC₂H₅) 72-76 are bonded to the silicon atom, yielding teovs. The three oxygen atoms of the triethoxy group donate electrons to Cu to increase the temperature stability of compound 60. The possible alkyloxy groups include all groups based on C1-C8 carbon chains; alkyloxy groups based on 1, 2, 3, 4, 5, 6, 7, or 8 carbon atoms. These alkyloxy groups include methoxy (when at least one C2-C8 alkyloxy group is present), ethoxy, propoxy, butoxy, pentyloxy, hexyloxy, heptyloxy, octyloxy, and aryloxy. The three alkyloxy groups need not have the same number of carbon atoms. For example, ligand 60 includes methoxy, ethoxy, and butoxy in one preferred embodiment. The alkyloxy groups are straight, branch, and cyclic chains, both saturated and saturated, as is well known in the art. In addition, the chains are also combination chains, such as a cyclic chain and a straight chain.

Fig. 4c is a schematic representation of another preferred embodiment of precursor 60 of Fig. 4a, where the (alkyloxy)(alkyl)silylolefin ligand is a diethoxyethylvinylsilane (deoevs) ligand 80. Two ethoxy groups 82-84 and one ethyl group 86 are bonded to the silicon atom, yielding deoevs. The two oxygen atoms of the diethoxyethyl group donate electrons to Cu to increase the temperature stability of precursor 60. Ligand 80 has fewer oxygen atoms than ligand 70, and therefore, fewer electrons to donate. However, the molecular weight of ligand 80, for the same reason, is less than ligand 70. The ability to adjust the molecular weight of compound 60 is useful in adjusting the vaporization temperatures and vacuum pressures of precursor 60 to match specific process requirements. As discussed with Fig. 4b, the possible alkyloxy groups include methoxy (when at least one C2-C8 alkyloxy group is present), ethoxy, propoxy, butoxy, pentyloxy, hexyloxy, heptyloxy, octyloxy, and aryloxy. Likewise, the alkyl groups include methyl, ethyl, propyl, butyl, pentyl, hexyl, heptyl, octyl, and aryl. Alkyloxy groups having different numbers of carbon atoms are used in some preferred embodiments of precursor 60, for example, an ethoxy and methoxy group. Alkyl groups having different numbers of carbon atoms are used in some preferred embodiments of precursor 60, for example, an ethyl and methyl group. Likewise, different alkyloxy and alkyl groups, together in a ligand, having different numbers of carbon atoms are used in some preferred embodiments, for example, ethyl and methoxy. As above, the alkyloxy groups

Fig. 3a is a schematic representation of the volatile Cu precursor compound 100 of the present invention, using an alkylaminosilylolefin ligand, for the chemical vapor deposition (CVD) of Cu to selected surfaces. Precursor compound 100 comprises Cu⁺¹(hfac), and a silylolefin ligand including at least one alkylamino group 102 bonded to the silicon atom. Amino groups are typically centered around a single N atom. Like the oxygen atom of alkyloxy groups, when a nitrogen atom is attached to the silicon atom of the ligand, it is able to contribute electrons to the Cu atom through the olefin ligand to prevent premature decomposition of the precursor compound. The electron donation capability of the nitrogen in the alkylaminosilylolefin ligand provides a secure bond between the Cu and the ligand as the compound is heated to vaporization temperature. X groups 104 and 106 typically include further amino groups, alkyloxy groups, alkyl groups, or other molecular groups capable of bonding to the silicon atom.

Fig. 3b is a schematic representation of a preferred embodiment of the alkylaminosilylolefin ligand of Fig. 3a, in which a ligand 110 includes three alkylamino groups. Three amino groups 112-116 are bonded to the silicon atom. Each amino group includes a N atom and at least one R group. The R group is an atom, or group of atoms, that bonds to N. Typically, R groups include hydrogen (H) atoms, and C1-C8 carbon alkyl groups. Fig. 3b specifically depicts two straight chain R groups 112-114, and one branch chain R group 116. However, the amino groups represented in Fig. 3a include alkyl groups of all C1-C8 carbon chain varieties. Alkyl groups generally have 1, 2, 3, 4, 5, 6, 7, or 8 carbon atoms (C1-C8). That is, the alkyl groups consist of methyl, ethyl, propyl, butyl, pentyl, hexyl, heptyl, octyl, and aryl.

When R groups of an amino group represent multiple alkyl groups, the number of carbon atoms in the multiple alkyl groups is different is some preferred embodiments. For example, amino group 116 of Fig. 3b includes an ethyl and methyl group in one embodiment of the invention. The list of all these possible variations is well known to those skilled in the art, but form a group too large to conveniently list. The large variety of amino groups and alkyl groups included in all embodiments, and the large variety of other groups that are bondable to the silicon atom, in addition to amino groups, permit the user to "fine tune" the precursor to optimize characteristics of the precursor important to a specific commercial process. For example, the alkyl groups of amino group 116 are selected, in one embodiment, to minimize carbon impurities, and in another embodiment, to maximize conformal, or step, coverage of high aspect IC geometries. Other embodiments include selecting alkyl groups to maximize specific precursor characteristics such as thermal stability, vapor pressure, viscosity (of liquid state precursor), conductivity of deposited Cu, cost of producing the precursor, cost of using the precursor, and maintaining the liquid state of the precursor at room temperature.

Fig. 4a is a schematic representation of the ligand of Fig. 3a, further including alkyloxy groups bonded to the silicon atom. In this preferred embodiment, a silylolefin ligand 120 further includes alkyloxy groups bonded to the silicon atom when at least one alkylamino group is included. That is, when alkylamino group 122 is present in the ligand, an alkyloxy group 124 is present. The electron donation capability of (alkylamino)(alkyloxy)silylolefin ligand 120 provides a secure bond between the Cu and ligand 120 as compound 100 (Fig. 3a) is heated to vaporization temperature. X group 126 is any molecular group capable of bonding to silicon and typically includes alkyl groups, another alkyloxy group, or another amino group.

Fig. 4b is a schematic representation of a preferred embodiment of the ligand of Fig. 4a, in which a ligand 130 includes two amino groups 132-134 and one alkyloxy group 136. Specifically, Fig. 4b depicts alkyloxy group 136 as methoxy (OCH₃). Alternately, alkyloxy group 136 is any C1-C8 alkyloxy group, including all straight, branched, cyclic, combination chain, unsaturated, and saturated variations.

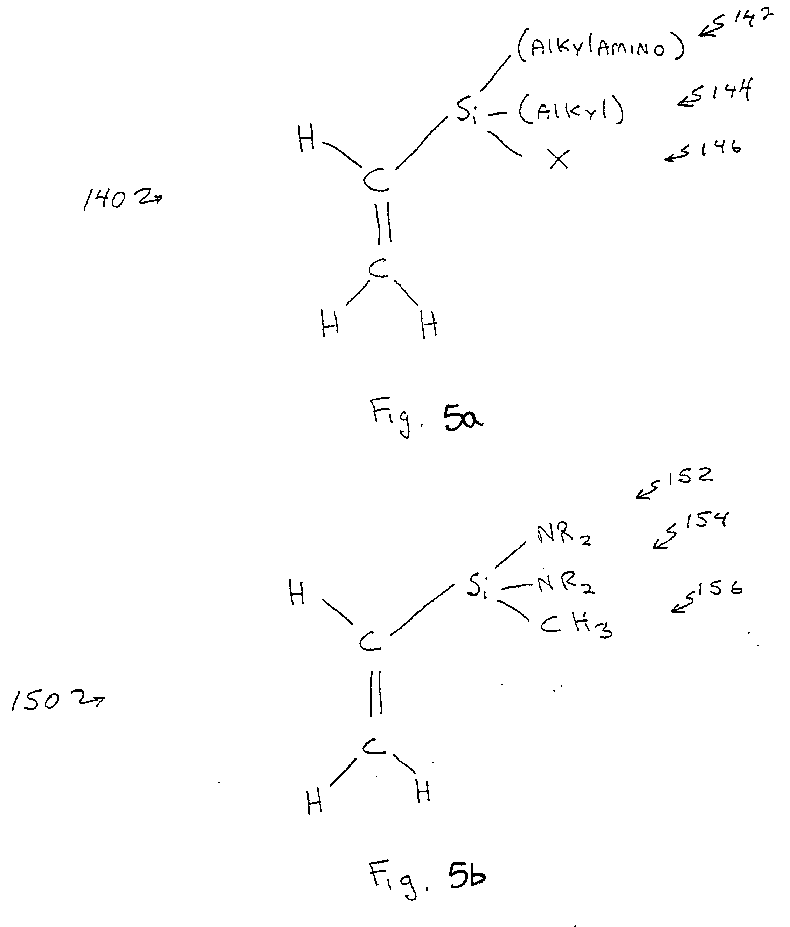

Fig. 5a is a schematic representation of the ligand of Fig. 3a, further including alkyl groups bonded to the silicon atom. In a preferred embodiment, silylolefin ligand 140 further includes alkyl groups bonded to the silicon atom when at least one alkylamino is included. That is, when an alkylamino 142 is present in the ligand, an alkyl group 144 is present. The molecular weight of (alkylamino)(alkyl)silylolefin ligand 140 minimally suppresses the precursor volatility. X group 146 is any molecular group capable of bonding to silicon, and typically includes alkyloxy groups, another alkyl group, or another amino group.

Fig. 5b is a schematic representation of a preferred embodiment of the ligand of Fig. 5a, in which a ligand 150 includes two amino groups 152-154 and one alkyl group 156. Specifically, Fig. 5b depicts alkyl group 156 as methyl (CH₃). Alternately, alkyl group 156 is any C1-C8 alkyl group, including all straight, branched, cyclic, and combination carbon chains, all unsaturated, and saturated variations.

Fig. 6a is a schematic representation of the ligand of Fig. 3a, further including an alkyloxy group and an alkyl group bonded to the silicon atom, whereby the molecular weight and electron donating capability of ligand 160 is modifiable. That is, an alkylamino 162, an alkyloxy group 164, and an alkyl group 166 are all present in ligand 160. Alkyloxy group 164 and alkyl group 166 include all possible C1-C3 straight, branched, cyclic, combination chain, unsaturated, and saturated variations.

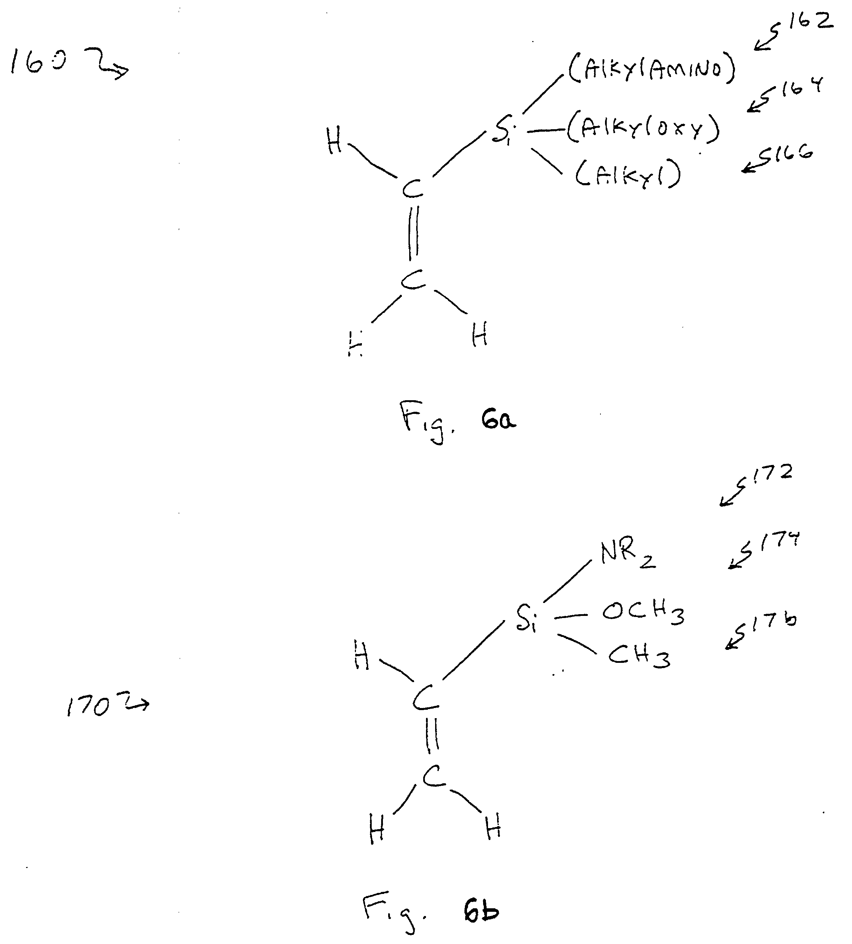

Fig. 6b is a schematic representation of a preferred embodiment of ligand 160 in Fig. 6a, in which a ligand 170 includes an amino group 172, an alkyloxy group 174, and an alkyl group 176. Specifically, Fig. 6b depicts alkyloxy group 174 as methoxy (OCH₃), and alkyl group 176 as methyl (CH₃). Alternately, alkyloxy group 174 is any C1-C8 alkyloxy group, and alkyl group 176 is any C1-C8 alkyl group, including all straight, branched, cyclic, unsaturated, and saturated variations. As above, alkyloxy group 174, alkyl group 176, and any alkyl groups included in amino group 172 have different numbers of carbon atoms in some preferred embodiments of the invention.

Alternately, volatile copper (Cu) precursor compound 100 of Fig. 3a is represented by the following structural formula:

(hfac)Cu(H₂C=C(H)SiX₃)

in which the X groups include at least one C0-C8 amino group bonded to the silicon atom. That is, as addressed above in Fig. 3b, the X group is a nitrogen group with no carbon atoms, or a nitrogen group bonded to an alkyl group having 1 through 8 carbon atoms. The electron donation capability of the nitrogen in the alkylamino group provides a secure bond between the Cu and the H₂C=C(H)SiX₃ ligand, as the compound is heated to vaporization temperature.

Ligand 120 of Fig. 4a is alternately represented in the format of the above structural formula as the X groups include alkyloxy groups bonded to the silicon atom when at least one alkylamino group is included. The oxygen atoms of the alkyloxy groups donate electrons to Cu to increase temperature stability of the precursor. Likewise, ligand 140 of Fig. 5a is represented in the format of the above structural formula as the X groups include alkyl groups bonded to the silicon when at least one alkylamino group is included. The molecular weight of the alkyl groups minimally suppresses the precursor volatility.

Ligand 160 of Fig. 6a is represented in the format of the above structural formula as the X groups include an alkyloxy group and an alkyl group bonded to the silicon atom when an alkylamino group is included, whereby the molecular weight and electron donating capability of the ligand is modifiable.

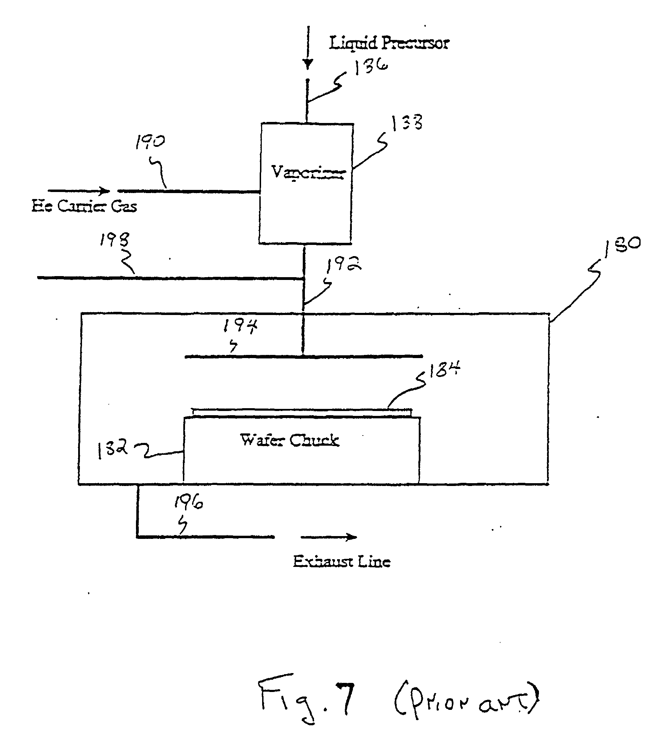

Fig. 7 is a block diagram of apparatus suitable to deposit Cu, with the precursor of the present invention, to selected surfaces (prior art). An environmental chamber 180 is capable of maintaining a pressurized environment. Inside chamber 180 is a wafer chuck 182, and upon wafer chuck 182 is an IC, or wafer, having a selected surface 184. Cu precursor, in its liquid form, is introduced into line 186, and then into vaporizer 188, where the precursor is heated until it is volatile. Helium, or some other inert carrier gas, is introduced into line 190, and then into vaporizer 188, where it is mixed with the volatile precursor. The volatile precursor and carrier gas are carried through a line 192 to chamber 180. Inside chamber 180 the precursor/carrier gas mixture is dispersed through a showerhead 194, or some other equivalent gas dispersal means. Exhaust gases exit chamber 180 through a line 196. Line 196 is connected to a pump (not shown) to maintain a predetermined vacuum pressure in chamber 180.

Line 198 is used to introduce additives to the volatile precursor, typically the additives are in a volatile or gaseous form. In the preferred embodiment of the invention, the precursor compound in line 192 includes an additive from line 198 to create a precursor blend. The precursor blend introduced to chamber 180 further comprises water vapor having a vacuum partial pressure. The partial pressure is the percentage of the precursor/carrier/water blend in line 192 that is a result of pressure of the water vapor. The water vapor is blended with the precursor in line 192 so that the partial pressure of the water vapor is generally in the range of 0.5 to 5% of the precursor partial pressure. The precursor partial pressure is the percentage of the precursor blend pressure in line 192 that is a result of the pressure of the volatile precursor. The addition of water vapor to the precursor increases the rate of Cu deposition and the electrical conductivity of the deposited Cu. Alternately, additives are pre-packaged in the liquid precursor, or mixed with the liquid precursor compound in line 186.

The Cu precursor in line 186 is vaporized, in vaporizer 188, at a temperature generally in the range between 40° C and 80° C. The Cu precursor in line 192 is applied, through showerhead 194, to each selected surface 184 at a temperature generally in the range between 40° C and 80° C. The Cu precursor is delivered in line 192 to each selected surface 184 with an inert gas. The inert gas, introduced in line 190, has a vacuum partial pressure generally in the range of 50% to 1000% of the precursor partial pressure.

Other materials are added to the Cu precursor compound in either its liquid form in line 186, or in a vapor form on line 198, to enhance particular characteristics of the precursor. In one embodiment, the compound includes an additive to create a precursor blend, with the precursor blend further comprising less than approximately 5% hexafluoroacetylacetone (H-hfac), as measured by weight ratio of the precursor compound. The H-hfac additive facilitates a Cu disproportionation reaction which enhances the Cu deposition rate. The disproportionation reaction causes the (hfac)⁻¹Cu⁺¹ to reconfigure the Cu atoms into either Cu⁺⁰ or Cu⁺² atoms. The uncharged Cu atoms become deposited on the selected surface, as an (hfac)₂Cu⁻² complex, and the ligands exit the process as exhaust gases in line 196.

Several preferred embodiments of the present invention operate to deposit Cu, without and water, H-hfac, H-hfac dihydrate, or silylolefin ligand additives. Such additives, when added to the Cu precursor compounds, significantly increase the cost and difficulty of making the precursor. However, there is a need to maximize the stability, efficiencies, deposition rates, and viscosity's of Cu precursors in production environments. Therefore, it is likely that at least some amount of additives will be blended with the precursor of the present invention.

In one preferred embodiment, the precursor compound includes an additive to create a precursor blend, in which the precursor blend further comprises less than approximately 10% silylolefins, as measured by weight ratio of the precursor compound. The silylolefins are added to prevent the Cu from prematurely decomposing as the precursor is heated. The additional silylolefins help stabilize the precursor, if the ligand prematurely cleaves, by forming bonds with (hfac)Cu. The silylolefins are selected from the group of silylolefins consisting of alkyl and alkyloxy groups having 1 through 8 carbon atoms bonded to the silicon atom, and alkylamino groups consisting of H atoms, and alkyl groups having 1 through 8 carbon atoms bonded to the silicon atom. The straight chain, branched chain, cyclic, and combination chain, both saturated and unsaturated, forms of the alkyl groups are well known to those skilled in the art and too ponderous to list herein. As above, the silylolefin ligands also include alkyloxy groups, alkyl groups, and amino groups including alkyl groups, having different numbers of carbon atoms, and all the possible combinations of alkyloxy groups, alkyl groups, and amino groups.

Alternately, the Cu precursor compound includes an additive to create a precursor blend, with the blend including silylolefins having the following structural formula:

H₂C=C(H)SiX₃

in which each X group is selected from C1 through C8 alkyloxy groups, C1-C8 alkyl groups, and C0 through C8 amino groups bonded to the silicon atom. That is, the X groups may be all alkyloxy groups, all alkyl groups, all amino groups, or combinations of all three. The possible alkyl groups include methyl (C1), ethyl (C2), propyl (C3), butyl (C4), pentyl (C5), hexyl (C6), heptyl (C7), octyl (C8), and aryl groups, or combinations of these alkyl groups. Likewise, the possible alkyloxy groups include methoxy (C1), ethoxy (C2), propoxy (C3), butoxy (C4), pentyloxy (C5), hexyloxy (C6), heptyloxy (C7), octyloxy (C8), and aryloxy groups, or combinations of these alkyloxy groups. Both alkyl and alkyloxy groups are selected from unsaturated and saturated chains of straight and branched carbon atoms, from saturated and unsaturated cyclic carbon arrangements, and combination of cyclic, branched, and straight chains, as is well known in the art. The amino groups include groups of N and H atoms, as well as groups where N is bonded to all the possible alkyl groups mentioned above.

In one embodiment, the precursor compound includes an additive to create a precursor blend, the blend further comprises less than approximately 5% H-hfac·2H₂O (H-hfac dihydrate), as measured by weight ratio of the precursor compound, to increase the deposition rate of Cu. As noted above, the addition of water to the precursor generally increases the deposition rate of Cu on a selected surface.

In one embodiment, the precursor compound includes an additive to create a precursor blend, the blend further comprises less than approximately 0.4% H-hfac·2H₂O, as measured by weight ratio of the precursor compound, and less than approximately 5% silylolefins, as measured by weight ratio of the precursor compound. The additives increase the deposition rate of Cu, and increase the electrical conductivity of the deposited Cu. The additional silylolefins help stabilize the precursor as it is heated.

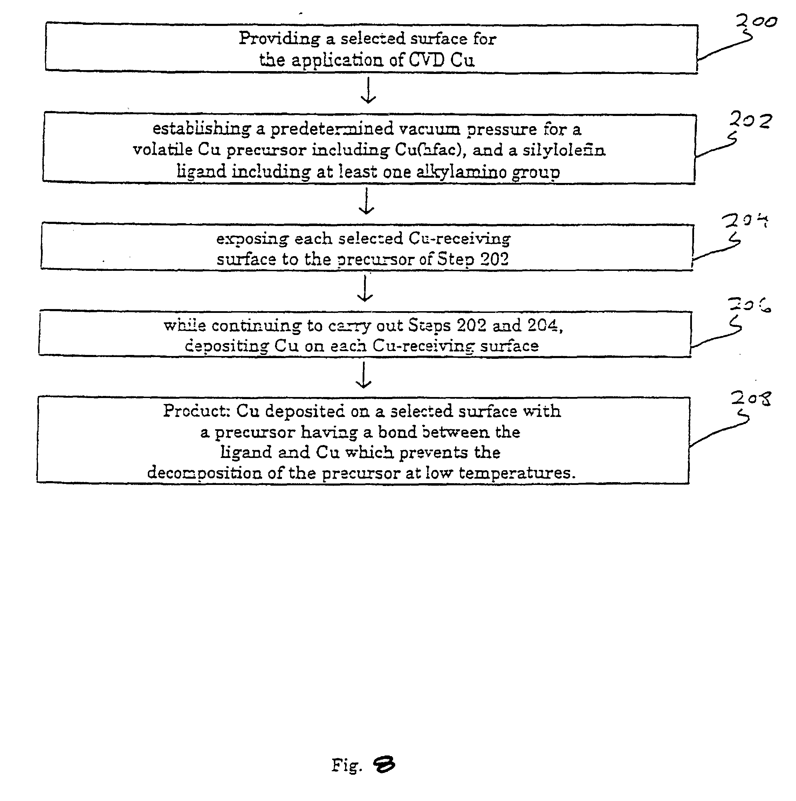

Fig. 8 illustrates steps in the method for applying CVD Cu on a selected surface. Step 200 provides a selected surface for the application of CVD Cu. Step 202 establishes a predetermined vacuum partial pressure for a volatile Cu precursor compound including Cu⁻¹(hexafluoroacetylacetonate) and a silylolefin ligand including at least one alkylamino group bonded to the silicon atom. Step 204 exposes each selected Cu-receiving surface to the precursor of Step 202. Step 206, while continuing to carry out Steps 202 and 204, deposits Cu on each Cu-receiving surface. Step 208 is a product, Cu deposited on a selected surface with a precursor having a bond between the ligand and Cu which prevents the decomposition of the precursor at low temperatures. A low temperature is typically the temperature at which the precursor is stored, or the temperature at which the precursor is transported from storage to vaporizer.

The preferred embodiment includes the further step of, simultaneously with Step 204, exposing each selected Cu-receiving surface to water vapor at a vacuum partial pressure generally in the range between 0.5 and 5% of the precursor partial pressure. The addition of water vapor to the precursor increases the rate of Cu deposition and the electrical conductivity of the deposited Cu.

The Cu-receiving, or selected surface, of the above method corresponds to selected surface 184 in Fig. 7. In the preferred embodiment, Step 202 includes vaporizing the Cu precursor at a temperature generally in the range between 40° C and 80° C. Step 204 includes applying the Cu precursor to each selected surface 184 at a temperature generally in the range between 40° C and 80° C. Each Cu-receiving surface in Step 204 has a temperature generally in the range between 160 and 250° C. It is the relatively high temperature of the target surface that preferably causes the Cu precursor to decompose, and so deposit uncharged Cu atoms on the surface. Cu is deposited on each Cu-receiving surface in Step 206 for a time generally in the range between 100 and 1000 seconds. That is, the controlled deposition process occurs within 100 to 1000 seconds.

The precursor of the present invention offers Process Engineers a modifiable (hfac)Cu(ligand) precursor. The precursor includes a variety of amino groups, combinations of amino groups and alkyloxy groups, amino groups and alkyl groups, or amino groups, alkyloxy groups, and alkyl groups. The precursor is modifiable with respect to molecular weight, and electron donation capability. The molecular weight is changed by the substitution of a wide variety of amino, alkyl, and alkyloxy groups with carbon chains of different lengths. Ongoing research suggests that molecular weight, the length of molecule chains, and the configuration of atoms attached either directly, or indirectly, to the silicon atom of the silylolefin ligand, dramatically affect the viscosity of the liquid precursor. These same elements also affect the vapor pressure obtainable with the volatile precursor before it begins to decompose. High vapor pressures at relatively low application temperatures result in a simple to use precursor that deposits thick layers of Cu on surfaces. The precursor of the present invention also offers a variety of groups attached to the silicon atom which supply electrons from oxygen, N, or both N and oxygen atoms to improve thermal stability.

The ligands of the present invention possess a family of unique characteristics. The characteristics of a particular ligand are utilized in specific situations, depending on the production environment, surface geometries, or process techniques that require differences in vaporization temperature and volatile precursor vacuum pressures. Alternate embodiments of the precursor permit it to be blended with water, silylolefins, H-hfac, H-hfac dihydrate, and combinations of additives to enhance deposition rates, Cu conductivity, and to minimize premature decomposition. These additives are blended with the precursor in either its liquid or volatile state. Other embodiments of the invention will occur to those skilled in the art.

## Claims

1. A volatile precursor compound for use in the chemical vapor deposition of copper, comprising:
Cu⁺¹(hexafluoroacetylacetonate); and
a silylolefin ligand including at least one alkylamino group the nitrogen atom of which is bonded to the silicon atom.

2. A precursor compound according to claim 1, in which the silylolefin ligand further includes one or more alkyloxy groups bonded to the silicon atom.

3. A precursor compound according to claim 1, in which the silylolefin ligand further includes one or more alkyl groups bonded to the silicon atom.

4. A precursor compound according to claim 1, in which he silylolefin ligand further includes an alkyloxy group and an alkyl group bonded to the silicon atom.

5. A precursor compound according to any one of claims 1 to 4, which further comprises:
less than 5% hexafluoracerylacetone (Hhfac), based on the weight of the precursor compound.

6. A precursor compound according to any one of claims 1 to 5, which further comprises:
less than 10% silylolefin, based on the weight of the precursor compound.

7. A precursor compound according to claim 6, wherein the silylolefin is selected from silylolefins consisting of alkyl and alkyloxy groups having 1 to 8 carbon atoms bonded to the silicon atom, and alkylamino groups consisting of H atoms, and alkyl groups having 1 to 8 carbon atoms bonded to the silicon atom.

8. A precursor compound according to any one of claims 1 to 7, which further comprises:
less than 5% Hhfac·2H₂O, based on the weight of the precursor compound.

9. A precursor compound according to any one of claims 1 to 8, which further comprises:
less than 0.4% Hhfac·2H₂O and less than 5% silylolefin, based on the weight of the precursor compound.

10. A volatile copper precursor compound for use in the chemical vapor deposition of copper having the general formula:
(hfac)Cu(H₂C=C(H)SiX₃)
in which the X groups include at least one C0-C8 amino.

11. A precursor compound according to claim 10, in which the X groups include at least one alkyloxy when at least one X is alkylamino.

12. A precursor compound according to claim 10, in which the X groups include at least one alkyl when at least one X is alkylamino.

13. A precursor compound according to claim 10, in which the X groups include an alkyloxy, an alkyl and an alkylamino.

14. A precursor compound according to any one of claims 10 to 13, further comprising a silylolefin having the general formula:
H₂C=C(H)SiX₃
in which each X is selected from C1-C8 alkyloxy, C1-C8 alkyl and C0-C8 amino.

15. A method for applying copper to a selected surface by chemical vapor deposition, the method comprising the steps of:
(a) establishing a predetermined reduced partial pressure for a volatile precursor compound according to any one of claims 1 to 14 to vaporise the precursor compound;
(b) exposing the selected surface to the vapor produced in step (a); and
(c) depositing copper on the selected surface.

16. A method according to claim 15, wherein the selected surface is simultaneously exposed to water vapor at a partial pressure between 0.5 and 5% of that of the precursor compound.

17. A method according to claim 15 or claim 16, wherein the selected surface has a temperature between 160 and 250°C.

18. A method according to any one of claims 15 to 17, wherein copper is deposited on the selected surface for a time period between 100 and 1000 seconds.

19. A method according to any one of claims 15 to 18, wherein the precursor compound vapor has a temperature between 40 and 80°C

20. A method according to any one of claims 15 to 19, which comprises delivering the vapor of the precursor compound to the selected surface with an inert gas having a partial pressure of 50 to 1000% of that of the precursor compound.

## Patentansprüche

1. Flüchtige Vorläuferverbindung zur Verwendung bei der chemischen Dampfabscheidung von Kupfer, mit:
- Cu⁺¹ (Hexafluoracetylacetonat) und
- einem Silylolefin-Liganden mit mindestens einer Alkylaminogruppe, deren Stickstoffatom an das Siliciumatom gebunden ist.

2. Vorläuferverbindung nach Anspruch 1, bei der der Silylolefin-Ligand ferner über eine oder mehrere Alkyloxygruppen verfügt, die an das Siliciumatom gebunden sind.

3. Vorläuferverbindung nach Anspruch 1, bei der der Silylolefin-Ligand ferner eine oder mehrere Alkylgruppen enthält, die an das Siliciumatom gebunden sind.

4. Vorläuferverbindung nach Anspruch 1, bei der der Silylolefin-Ligand ferner eine Alkyloxygruppe und eine Alkylgruppe, mit Bindung an das Siliciumatom, enthält.

5. Vorläuferverbindung nach einem der Ansprüche 1 bis 4, die ferner weniger als 5 % Hexafluoracetylaceton (Hhfac) bezogen auf das Gewicht der Vorläuferverbindung enthält.

6. Vorläuferverbindung nach einem der Ansprüche 1 bis 5, die ferner weniger als 10 % Silylolefin bezogen auf das Gewicht der Vorläuferverbindung enthält.

7. Vorläuferverbindung nach Anspruch 6, bei der das Silylolefin aus solchen Silylolefinen ausgewählt ist, die über Alkyl- und Alkyloxygruppen mit 1 bis 8 an das Siliciumatom gebundenen Kohlenstoffatomen und Alkylaminogruppen mit H-Atomen und Alkylgruppen bis 1 bis 8 an das Siliciumatom gebundenen Kohlenstoffatomen verfügen.

8. Vorläuferverbindung nach einem der Ansprüche 1 bis 7, die ferner weniger als 5 % Hhfac·2H₂O auf Grundlage des Gewichts der Vorläuferverbindung enthält.

9. Vorläuferverbindung nach einem der Ansprüche 1 bis 8, die ferner weniger als 0,4 % Hhfac·2H₂O und weniger als 5 % Silylolefin bezogen auf das Gewicht der Vorläuferverbindung enthält.

10. Flüchtige Kupfer-Vorläuferverbindung zur Verwendung bei der chemischen Dampfabscheidung von Kupfer, mit der Gattungsformel :
(hfac)Cu(H₂C)SiX₃),
wobei die X-Gruppen mindestens eine C0-C8-Aminogruppe enthalten.

11. Vorläuferverbindung nach Anspruch 10, bei der die X-Gruppen mindestens eine Alkyloxygruppe enthalten, wenn mindestens ein X eine Alkylaminogruppe ist.

12. Vorläuferverbindung nach Anspruch 10, bei der die X-Gruppen mindestens eine Alkylgruppe enthalten, wenn mindestens ein X eine Alkylaminogruppe ist.

13. Vorläuferverbindung nach Anspruch 10, bei der die X-Gruppen eine Alkyloxy-, eine Alkyl- und eine Alkylaminogruppe enthalten.

14. Vorläuferverbindung nach einem der Ansprüche 10 bis 13, ferner mit einem Silylolefin mit der Gattungsformel:
H₂C = C(H)SiX₃
bei der X aus C1-C8-Alkoxy, C1-C8-Alkyl und C0-C8-Amino ausgewählt ist.

15. Verfahren zum Auftragen von Kupfer auf eine ausgewählte Fläche durch chemische Dampfabscheidung, mit den folgenden Schritten:
(a) Einstellen eines vorbestimmten verringerten Partialdrucks für eine flüchtige Vorläuferverbindung nach einem der Ansprüche 1 bis 14, um diese zu verdampfen;
(b) die ausgewählte Fläche wird dem im Schritt (a) erzeugten Dampf ausgesetzt; und
(c) Abscheiden von Kupfer auf der ausgewählten Fläche.

16. Verfahren nach Anspruch 15, bei dem die ausgewählte Fläche gleichzeitig Wasserdampf mit einem Partialdruck zwischen 0,5 und 5 % desjenigen der Vorläuferverbindung ausgesetzt wird.

17. Verfahren nach Anspruch 15 oder Anspruch 16, bei dem die ausgewählte Fläche eine Temperatur zwischen 160 und 250°C aufweist.

18. Verfahren nach einem der Ansprüche 15 bis 17, bei dem Kupfer für eine Zeitperiode zwischen 100 und 1000 Sekunden auf der ausgewählten Fläche abgeschieden wird.

19. Verfahren nach einem der Ansprüche 15 bis 18, bei dem der Dampf der Vorläuferverbindung eine Temperatur zwischen 40 und 80°C aufweist.

20. Verfahren nach einem der Ansprüche 15 bis 19, bei dem der Dampf der Vorläuferverbindung der ausgewählten Fläche mit einem Inertgas mit einem Partialdruck von 50 bis 1000 % desjenigen der Vorläuferverbindung zugeführt wird.

## Revendications

1. Composé précurseur volatil pour utilisation dans le dépôt de cuivre en phase gazeuse par procédé chimique, comprenant :
du Cu⁺¹ (hexafluoroacétylacétonate); et
un ligand de silyloléfine comprenant au moins un groupe alkylamino dont l'atome d'azote est lié à l'atome de silicium.

2. Composé précurseur selon la revendication 1, dans lequel le ligand de silyloléfine comprend en outre un ou plusieurs groupes alkyloxy liés à l'atome de silicium.

3. Composé précurseur selon la revendication 1, dans lequel le ligand de silyloléfine comprend en outre un ou plusieurs groupes alkyle liés à l'atome de silicium.

4. Composé précurseur selon la revendication 1, dans lequel le ligand de silyloléfine comprend en outre un groupe alkyloxy et un groupe alkyle liés à l'atome de silicium.

5. Composé précurseur selon l'une quelconque des revendications 1 à 4, qui comprend en outre moins de 5% d'hexafluoroacétylacétone (Hhfac) par rapport au poids du composé précurseur.

6. Composé précurseur selon l'une quelconque des revendications 1 à 5, qui comprend en outre moins de 10% de silyloléfine par rapport au poids du composé précurseur.

7. Composé précurseur selon la revendication 6, dans lequel la silyloléfine est choisie parmi les silyloléfines constituées de groupes alkyle et alkyloxy, ayant 1 à 8 atomes de carbone, liés à l'atome de silicium, et de groupes alkylamino constitués d'atomes H et de groupes alkyle ayant 1 à 8 atomes de carbone liés à l'atome de silicium.

8. Composé précurseur selon l'une quelconque des revendications 1 à 7, qui comprend en outre moins de 5% de Hhfac·2H₂O par rapport au poids du composé précurseur.

9. Composé précurseur selon l'une quelconque des revendications 1 à 8, qui comprend en outre moins de 0,4% de Hhfac·2H₂O et moins de 5% de silyloléfine par rapport au poids du composé précurseur.

10. Composé précurseur de cuivre volatil pour utilisation dans le dépôt en phase gazeuse par procédé chimique de cuivre ayant la formule générale :
(hfac)Cu(H₂C=C(H)SiX₃)
dans laquelle les groupes X comprennent au moins un groupe amino en C₀-C₈.

11. Composé précurseur selon la revendication 10, dans lequel les groupes X comprennent au moins un alkyloxy lorsqu'au moins un groupe X est alkylamino.

12. Composé précurseur selon la revendication 10, dans lequel les groupes X comprennent au moins un groupe alkyle lorsqu'au moins un groupe X est alkylamino.

13. Composé précurseur selon la revendication 10, dans lequel les groupes X comprennent un alkyloxy, un alkyle et un alkylamino.

14. Composé précurseur selon l'une quelconque des revendications 10 à 13, comprenant en outre une silyloléfine ayant pour formule générale :
H₂C=C(H)SiX₃
dans laquelle chaque groupe X est choisi parmi alkyloxy en C₁-C₈, alkyle en C₁-C₈ et amino en C₀-C₈.

15. Procédé d'application de cuivre sur une surface choisie, par dépôt en phase gazeuse par procédé chimique, comprenant les étapes consistant :
(a) à établir une pression partielle réduite prédéterminée pour un composé précurseur volatil selon l'une quelconque des revendications 1 à 14 afin de vaporiser le composé précurseur;
(b) à exposer la surface choisie à la vapeur produite à l'étape (a); et
(c) à déposer du cuivre sur la surface choisie.

16. Procédé selon la revendication 15, dans lequel la surface choisie est simultanément exposée à de la vapeur d'eau à une pression partielle située entre 0,5% et 5% de celle du composé précurseur.

17. Procédé selon la revendication 15 ou 16, dans lequel la surface choisie a une température située entre 160°C et 250°C.

18. Procédé selon l'une quelconque des revendications 15 à 17, dans lequel du cuivre est déposé sur la surface choisie pendant une période de temps comprise entre 100 et 1000 secondes.

19. Procédé selon l'une quelconque des revendications 15 à 18, dans lequel la vapeur du composé précurseur a une température située entre 40°C et 80°C.

20. Procédé selon l'une quelconque des revendications 15 à 19, qui comprend l'opération consistant à amener la vapeur du composé précurseur sur la surface choisie avec un gaz inerte ayant une pression partielle de 50% à 1000% de celle du composé précurseur.
